(19) **Europäisches Patentamt**
**European Patent Office**
**Office européen des brevets**

(11) **EP 2 984 213 B1**

(12) **FASCICULE DE BREVET EUROPEEN**

(45) Date de publication et mention
de la délivrance du brevet:
**22.06.2022 Bulletin 2022/25**

(21) Numéro de dépôt: **14722265.7**

(22) Date de dépôt: **11.04.2014**

(51) Classification Internationale des Brevets (IPC):
**C30B 11/00** (2006.01)    **C30B 15/00** (2006.01)
**C30B 29/12** (2006.01)    **C09K 11/77** (2006.01)

(52) Classification Coopérative des Brevets (CPC):
**C09K 11/77; C09K 11/7766; C09K 11/7773;
C30B 11/00; C30B 15/00; C30B 29/12**

(86) Numéro de dépôt international:
**PCT/FR2014/050893**

(87) Numéro de publication internationale:
**WO 2014/167262 (16.10.2014 Gazette 2014/42)**

(54) **FABRICATION D'UN MATERIAU SCINTILLATEUR DU TYPE ELPASOLITE**

HERSTELLUNG EINES ELPASOLIT-SZINTILLATORMATERIALS

PRODUCTION OF AN ELPASOLITE-TYPE SCINTILLATOR MATERIAL

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **12.04.2013 FR 1353354**

(43) Date de publication de la demande:
**17.02.2016 Bulletin 2016/07**

(73) Titulaire: **SAINT-GOBAIN CRISTAUX &
DETECTEURS
92400 Courbevoie (FR)**

(72) Inventeurs:
• **OUSPENSKI, Vladimir
F-77140 Saint-Pierre les Nemours (FR)**
• **BLAHUTA, Samuel
F-94120 Fontenay-sous-Bois (FR)**
• **HUCHET, Raphaël
F-60350 Autreches (FR)**
• **LEJAY, Julien
F-92500 Rueil Malmaison (FR)**

(74) Mandataire: **Saint-Gobain Recherche
Département Propriété Industrielle
39 Quai Lucien Lefranc
93300 Aubervilliers (FR)**

(56) Documents cités:
**WO-A1-2005/021680    WO-A2-2013/041251**

**US-A1- 2011 024 635    US-B1- 7 977 645**

• **AULL B F ET AL: "Impact of ion-host interactions on the 5d-to-4f spectra of lanthanide rare-earth-metal ions. II. The Ce-doped elpasolites", PHYSICAL REVIEW, B. CONDENSED MATTER, AMERICAN INSTITUTE OF PHYSICS. NEW YORK, US, vol. 34, no. 10, 15 novembre 1986 (1986-11-15), pages 6647-6655, XP002475697, ISSN: 0163-1829, DOI: 10.1103/PHYSREVB.34.6647**
• **brian francis aull: "the impact of ion-host interactions on the 5d-to-4f spectra of lanthanide rare earth ions", 19 juillet 1985 (1985-07-19), Massachusetts institute of technology, Massachusetts institute of technology, XP008167107, run 450F of table II; pages 79,86; tableau III run 14B of table IV; pages 80,87; tableau IV**
• **W. M. HIGGINS, J. GLODO, U. SHIRWADKAR, A. CHURILOV, E. VAN LOEF, R. HAWRAMI, G. CIAMPI, C. HINES, K. S. SHAH: "Bridgman growth of Cs2LiYCl6:Ce and 6Li-enriched Cs2LiYCl6:Ce crystals for high resolution gamma ray and neutron spectrometers", JOURNAL OF CRYSTAL GROWTH, vol. 312, 6 octobre 2009 (2009-10-06), pages 1216-1220, XP002719526, DOI: 10.1016/j.jcrysgro.2009.09.046**

- **U. SHIRWADKAR, J. GLODO, E. V. VAN LOEF, R. HAWRAMI, S. MUKHOPADHYAY, A. CHURILOV, W. M. HIGGINS, K. S. SHAH: "scintillation properties of Cs2LiLaBr6 (CLLB) crystals with varying Ce3+ concentration", NUCLEAR INSTRUMENTS AND METHODS IN PHYSICS RESEARCH A, vol. 652, 7 septembre 2010 (2010-09-07), pages 268-270, XP002719527, DOI: 10.1016/j.nima.2010.08.050**
- **J. Glodo, R. Hawrami, E. van Loef, W. Higgins, U. Shirwadkar, K. S. Shah: "dual gamma neutron detection with Cs2LiLaCl" In: R. B James, L: A: Franks, A; Burger: "Hard X-Ray, Gamma-Ray, and Neutron Detector Physics XI", 31 décembre 2009 (2009-12-31), Proc. of SPIE, XP002719563, vol. 7449, pages 74490E-1-74490E-7, DOI: 10.1117/12.83127, abrégé; figure 2**
- **JAREK GLODO ET AL: "Selected Properties of Cs $_{2}$ LiYCl $_{6}$ , Cs $_{2}$ LiLaCl $_{6}$ , and Cs $_{2}$ LiLaBr $_{6}$ Scintillators", IEEE TRANSACTIONS ON NUCLEAR SCIENCE, IEEE SERVICE CENTER, NEW YORK, NY, US, vol. 58, no. 1, 1 février 2011 (2011-02-01), pages 333-338, XP011334601, ISSN: 0018-9499, DOI: 10.1109/TNS.2010.2098045**
- **JAREK GLODO ET AL: "Pulse Shape Discrimination With Selected Elpasolite Crystals", IEEE TRANSACTIONS ON NUCLEAR SCIENCE, IEEE SERVICE CENTER, NEW YORK, NY, US, vol. 59, no. 5, 1 octobre 2012 (2012-10-01), pages 2328-2333, XP011467412, ISSN: 0018-9499, DOI: 10.1109/TNS.2012.2188646**
- **MROCZKOWSKI S ET AL: "Preparation of Rb2NaYF6:Ce<3+> and Cs2NaYF6:Ce<3+> - prospect for tunable lasers in the blue-green wavelength", JOURNAL OF THE LESS-COMMON METALS, ELSEVIER-SEQUOIA S.A. LAUSANNE, CH, vol. 110, no. 1-2, 1 août 1985 (1985-08-01), pages 259-265, XP024072828, ISSN: 0022-5088, DOI: 10.1016/0022-5088(85)90332-7 [extrait le 1985-08-01]**
- **PETER A. TANNER, CHRIS S. K. MAK, NORMAN M. EDELSTEIN, KEITH M. MURDOCH, GUOKIU LIU, JIN HUANG, LUIS SEIJO, AND ZOILA BARANDIARÁN: "Absorption and emission spectra of Ce3+ in elpasolite lattices", J. AM. CHEM. SOC., vol. 125, 4 octobre 2003 (2003-10-04), pages 13225-13233, XP002719564, DOI: 10.1021/ja036659x**
- **CHRISTIAN REBER, HANS U. GUEDEL, GERD MEYER, THOMAS SCHLEID, CLAUDE A. DAUL: "Optical spectroscopic and structural properties of V3+-doped fluuoride, chloride and bromide elpasolite lattices", INORG. CHEM., vol. 28, 1 janvier 1989 (1989-01-01), pages 3249-3258, XP002719565, DOI: 10.1021/ic00315a034**
- **REBER C ET AL: "Near-infraded luminescence spectroscopy and relaxation behaviour of V<3+> doped in Cs2NaYCl6-mBrm(m =0, 0.3, 3, 6", JOURNAL OF LUMINESCENCE, ELSEVIER BV NORTH-HOLLAND, NL, vol. 42, no. 1, 1 juin 1988 (1988-06-01), pages 1-13, XP024431388, ISSN: 0022-2313, DOI: 10.1016/0022-2313(88)90059-2 [extrait le 1988-06-01]**
- **U. SHIRWADKAR ET AL: "Novel scintillation material Cs<inf>2</inf>LiLaBr<inf>6-x</inf>Cl<inf>x</inf>:Ce for gamma-ray and neutron spectroscopy", 2012 IEEE NUCLEAR SCIENCE SYMPOSIUM AND MEDICAL IMAGING CONFERENCE RECORD (NSS/MIC), 27 octobre 2012 (2012-10-27), - 3 novembre 2012 (2012-11-03), pages 1963-1967, XP055125390, DOI: 10.1109/NSSMIC.2012.6551453 ISBN: 978-1-46-732029-0**
- **GORYUNOV A V ET AL: "Crystal structure of lithium and yttrium complex fluorides", MATERIALS RESEARCH BULLETIN, ELSEVIER, KIDLINGTON, GB, vol. 27, no. 2, 1 février 1992 (1992-02-01), pages 213-220, XP024077860, ISSN: 0025-5408, DOI: 10.1016/0025-5408(92)90215-L [extrait le 1992-02-01]**
- **F Patrick Doty ET AL: "Elpasolite Scintillators", SANDIA REPORT SAND2012-9951, 1 December 2012 (2012-12-01), XP055629486, Retrieved from the Internet: URL:https://prod.sandia.gov/techlib/access -control.cgi/2012/129951.pdf [retrieved on 2019-10-07]**
- **FRANCESCO L. RUTA ET AL: "Abstract", JOURNAL OF MATERIALS RESEARCH, vol. 32, no. 12, 22 May 2017 (2017-05-22), pages 2373-2380, XP055771414, US ISSN: 0884-2914, DOI: 10.1557/jmr.2017.168**

Remarques:

Le dossier contient des informations techniques présentées postérieurement au dépôt de la demande et ne figurant pas dans le présent fascicule.

**Description**

L'invention concerne un procédé de fabrication d'une phase elpasolite d'halogénure de terre rare ou de métaux, notamment monocristalline, avec de bons rendements.

Les matériaux scintillateurs sont largement utilisés pour la détection de rayonnements gamma ou X ainsi que des particules énergétiques telles que les particules alpha, les neutrons, etc.

La scintillation repose sur le principe physique de la conversion en lumière dans ou proche du domaine du visible de l'énergie de photons, de rayons X ou gamma incidents ou de particules énergétiques. Notamment, les scintillateurs inorganiques sont de préférence monocristallins ou polycristallins. Un monocristal permet une extraction plus facile de la lumière grâce à l'absence de diffusion interne à travers des joints de grains, des hétérogénéités et d'autres défauts présents dans les matériaux polycristallins. Un état de bonne cristallinité est nécessaire, car il détermine les mécanismes de scintillation les plus performants. La lumière extraite est ensuite recueillie par un dispositif bien connu de l'homme du métier comme un tube photomultiplicateur, une photodiode, un SiPM (photomultiplicateur en silicium), une APD (photodiode à avalanche), etc. Un scintillateur polycristallin peut être réalisé à partir de poudres compactées ou frittées ou enrobées avec un liant de manière à toujours permettre une extraction de lumière. Souvent, ces matériaux non monocristallins sont trop opaques au-delà d'une certaine épaisseur par ailleurs insuffisante pour arrêter suffisamment de particules ou photons énergétiques incidents. Généralement, un matériau scintillateur monocristallin est préféré. La détection des photons gamma, particules alpha ou bêta, des particules chargées ou des neutrons est d'un intérêt majeur dans de nombreuses applications en médecine nucléaire, en physique fondamentale, pour les scanners de sécurité pour les bagages (portiques de détection), le contrôle en continu des containers et camions aux frontières, les systèmes de diagnostic géophysique dans les mines et pour les forages pétroliers, etc. Dans ces applications, il est par ailleurs souvent souhaitable de pouvoir distinguer les neutrons des rayonnements gamma et un détecteur à scintillation devrait dans ce cas être en mesure de produire des signaux de caractéristiques de luminescence différents en fonction du type de rayonnement. Le WO2005/068585 enseigne un scintillateur elpasolite de ce type. Le US8362439 enseigne un mélange de scintillateurs elpasolite.

Le document AULL B F ET AL, "Impact of ion-host interactions on the 5d-to-4f spectra of lanthanide rare-earth-metal ions. II. The Ce-doped elpasolites", PHYSICAL REVIEW, B. CONDENSED MATTER, AMERICAN INSTITUTE OF PHYSICS. NEW YORK, US, vol. 34, no. 10, (1986-11-15), pages 6647-6655, XP002475697, enseigne la croissance de cristaux de Rb2NaYF6 et RbzNaScF6 éventuellement dopés au Cérium par les techniques verticales de Bridgman et Czochralski. Un excès en Na a été utilisé pour la croissance de certains cristaux.

Le document Brian Francis Aull, the impact of ion-host interactions on the 5d-to-4f spectra of lanthanide rare earth ions, Massachusetts institute of technology, (1985-07-19), XP008167107, enseigne la croissance de monocristaux de Rb2NaYF6 et Rb2NaScF6 par les techniques Bridgman et Czochralski. La tentative de croissance de K2NaYF6 par les deux méthodes n'a donné que des échantillons polycristallins.

Le document WO2013/041251A2 enseigne un matériau scintillateur, autre qu'un silicate de terre rare, pouvant inclure une terre rare dans un état divalent (RE 2+), trivalent (RE3 +) ou un tétravalent (RE4 +). Le scintillateur peut inclure un autre élément pour permettre un meilleur équilibre des charges.

Le document W. M. HIGGINS, J. GLODO, U. SHIRWADKAR, A. CHURILOV, E. VAN LOEF, R. HAWRAMI, G. CIAMPI, C. HINES, K. S. SHAH, "Bridgman growth of Cs2LiYCl6:Ce and 6Li-enriched Cs2LiYCl6:Ce crystals for high resolution gamma ray and neutron spectrometers", JOURNAL OF CRYSTAL GROWTH, vol. 312, 6 octobre 2009, pages 1216-1220, XP002719526, enseigne des performances de scintillation de monocristaux de Cs2LiYCl6 de petit et de grand diamètre réalisés en Bridgman.

Le document U. SHIRWADKAR, J. GLODO, E. V. VAN LOEF, R. HAWRAMI, S. MUKHOPADHYAY, A. CHURILOV, W. M. HIGGINS, K. S. SHAH, "scintillation properties of Cs2LiLaBr6 (CLLB) crystals with varying Ce3+ concentration", NUCLEAR INSTRUMENTS AND METHODS IN PHYSICS RESEARCH A, vol. 652, 7 septembre 2010, pages 268-270, XP002719527, enseigne des performances de scintillation de monocristaux de Cs2LiLaBr6 en fonction de la teneur en cérium.

J. Glodo, R. Hawrami, E. van Loef, W. Higgins, U. Shirwadkar, K. S. Shah: "dual gamma neutron detection with Cs2LiLaCl" In: R. B James, L: A: Franks, A; Burger: "Hard X-Ray, GammaRay, and Neutron Detector Physics XI", 31 décembre 2009, Proc. of SPIE, XP002719563, vol. 7449, pages 74490E-1-74490E-7, enseigne que des cristaux de Cs2LiLaCl (CLLC) dopé Ce permet la détection de radiations gamma et de neutrons.

Le document WO2005/021680A1 enseigne des elpasolites, de formule $A_{2-y}B_{1+y}Me^{3+}X_6$, dans laquelle

A est un ion monovalent tel que Li, Na, K, Rb, Cs, Cu, Ag,

B est un ion monovalent tel que Li, Na, K, Rb, Cs, Cu, Ag, A étant différent de B, Me 3+ est un ion trivalent, de préférence le gadolinium, et X est F, Cl, Br ou I, avec $0<y<1$ et $0<x<0,3$ .

Le document F. Patrick Doty et al, « Elpasolite Scintillators », Sandia Report SAND2012-9951, 1er décembre 2012, XP055629486 décrit la croissance par un procédé Bridgman de cristaux de $Cs_2LiLaBr_6$ :$Ce^{3+}$.

La démarche classique de l'homme du métier cherchant à fabriquer un monocristal d'elpasolite est de procéder à une cristallisation à partir d'un bain fondu dont la composition correspond à la stœchiométrie du cristal visé. Quel que soit le procédé de croissance cristalline utilisé, pour un grand nombre de compositions complexes (tri-composée ou encore plus complexes) existe le phénomène de la fusion non congruente. La cristallisation d'une phase principale d'elpasolite est accompagnée ou précédée de la précipitation d'une phase secondaire pouvant apparaître sous forme d'inclusions ou d'une zone monophasée d'une phase non souhaitée. On s'est maintenant aperçu que le matériau cristallin obtenu à partir du bain fondu de ces compositions complexes contenait une forte proportion d'inclusions, voire était uniquement composé de la phase secondaire parasite. Le matériau cristallin obtenu, du type monocristal ou polycristal, peut également être appelé lingot. Dans le cas d'un monocristal à fusion non-congruente, la phase secondaire est généralement localisée aux extrémités ou à la périphérie du matériau monocristallin. Cette phase secondaire forme des zones non transparentes perturbant le caractère monocristallin de la phase principale. Dans certains cas favorables, on peut quand même récupérer une partie du matériau monocristallin en éliminant ultérieurement ces zones non-utilisables par découpe et en conservant la partie monocristalline transparente exempte d'inclusions. Ces inclusions correspondent à des phases parasites de composition différente de celle recherchée. Selon l'invention, on a découvert un moyen de réduire la proportion de ces zones impures, voire même dans certains cas de les éliminer, procurant de ce fait de meilleurs rendements de fabrication.

En plus de l'obtention de meilleurs rendements de fabrication, l'invention permet l'obtention de cristaux à la composition plus proche de la stœchiométrie théorique de l'elpasolite, voire même de l'enrichir dans certains cas, notamment en certains éléments tels Li. Un enrichissement en Li est avantageux pour la détection des neutrons. Dans la plupart des cas, une composition plus proche de la stœchiométrie théorique se traduit par une meilleure transmission lumineuse et, en scintillation, par une meilleure résolution énergétique. De plus, l'invention permet l'utilisation du procédé de croissance dit Czochralski, ce qui a jusqu'à présent toujours été considéré par l'homme du métier comme étant impossible pour les cristaux à fusion non congruente et en particulier la majorité des cristaux de la famille elpasolite. En croissance Brigman, le procédé selon l'invention permet l'obtention de plus forts rendement matière en cristal utilisable, c'est-à-dire qu'il mène à un lingot comprenant moins de phase parasite pour une elpasolite à fusion non-congruente.

L'invention concerne un procédé selon la revendication 1 et un lingot selon la revendication 18. L'invention concerne un procédé de croissance monocristalline pour la fabrication d'un matériau cristallin scintillateur de structure de type elpasolite de composition théorique

$$A_2BC_{(1-y)}M_yX_{(6-y)} \qquad\qquad (1)$$

ledit matériau cristallin étant à fusion non congruente, dans laquelle

    o A est choisi parmi Cs, Rb, K, Na,
    o B est choisi parmi Li, K, Na, et comprend Li,
    o C est choisi parmi les terres rares, Al, Ga, et comprend une terre rare choisie parmi les Lanthanides de La à Lu, ou Y,
    o M est choisi parmi les alcalino-terreux, notamment Ca, Mg, Sr, Ba
    o X est choisi parmi F, Cl, Br, I, et comprend Cl, Br ou I,

y représentant la fraction atomique (ou fraction molaire) de substitution de C par M (les éléments C et M occupent les mêmes sites de l'elpasolite) et étant compris dans le domaine allant de 0 à 0,05 (ce qui signifie que y peut être nul), comprenant sa cristallisation par refroidissement à partir d'un bain fondu comprenant r moles de A et s moles de B, le bain fondu en contact avec le matériau contenant A et B de sorte que 2s/r soit supérieur à 1,05, ledit procédé utilisant une technique choisie parmi celles de Czochralski, Bridgman, Bagdasarov, Kyropoulos et la technique du Vertical Gradient Freeze.

Ce qui vient d'être dit ne signifie pas que le matériau cristallin scintillateur effectivement obtenu par le procédé selon l'invention a la composition stœchiométrique théorique. Cela dit qu'il mène à un cristal dont la formule serait la formule (1) si sa composition était effectivement théorique (c'est-à-dire stœchiométrique).

Les formules des matériaux effectivement réalisés peuvent être déterminées à partir des analyses élémentaires (ICP - plasma à couplage inductif - ou XRF - Fluorescence de Rayons X) en chaque élément (sauf Li dans le cas de XRF) et avec la convention que la somme des cations est 4 dans la formule de l'elpasolite.

Le fait que le rapport 2s/r soit supérieur à 1,05 est représentatif d'un « excès en B » dans le bain en fusion dans le cadre de la présente invention. C'est en ce sens que l'expression « excès en B » peut être utilisée dans le cadre de la présente demande. En effet, l'elpasolite théorique stœchiométrique est telle que le rapport du double du nombre de mole de B sur le nombre de mole de A est égal à 1. On a maintenant trouvé que ce rapport dans le cristal effectivement réalisé était en réalité inférieur à 1 en travaillant avec un 2s/r de 1 et que c'est en augmentant le rapport 2s/r relatif au bain fondu que l'on arrivait à se rapprocher et même atteindre voire même dépasser le rapport atomique (ou molaire) en B et A stœchiométrique dans l'elpasolite effectivement réalisée.

2s/r est supérieur à 1,05 et de manière encore préférée supérieur à 1,25 et même supérieur à 1,5. Notamment, 2s/r peut-être supérieur à 1,15. Notamment, 2s/r peut-être supérieur à 1,35. En cas de trop fort excès en B (trop fort rapport 2s/r), une phase parasite, peut se former donnant lieu également à des inclusions néfastes. De préférence, l'excès molaire en B dans le bain (et donc le rapport 2s/r) est insuffisant pour générer la formation d'une phase de $B_3C_{(1-y)}M_yX_6$ en début de cristallisation, et tout du moins il est suffisamment bas pour en générer le moins possible. Ainsi, 2s/r est de préférence inférieur à 10 et de manière encore préférée inférieur à 5. Notamment, 2s/r peut généralement être inférieur à 3.

Le rapport 2s/r se calcule à partir des quantités molaires en A et B introduites dans le bain. Les éléments A et B y sont introduits sous forme halogénée. Pour le cas où le bain contient K ou Na, compte tenu de ce que ces éléments peuvent aller sur les sites de type A ou sur les sites de type B, il convient de déterminer la proportion de ces éléments allant sur les sites A et les sites B par l'expérience pour pouvoir ensuite calculer le rapport 2s/r. Pour déterminer la proportion de Na et K se trouvant sur l'un ou l'autre site, on peut procéder à une étude structurale par diffraction des rayons X. Pour ce faire on utilise un porte-échantillon étanche empêchant la poudre de s'hydrater au contact de l'air ambiant et donc de se dégrader. En effet, ces matériaux sont très fortement hygroscopiques. L'excès selon l'invention en Na ou en K en tant qu'élément du type B se détermine donc à postériori à partir de la formule exacte de l'elpasolite finalement réalisée en déterminant le pourcentage relatif de Na ou K sur le site de type A ou celui de type B. En général, le Na va majoritairement sur le site de type B. A titre d'exemple, si une cristallisation a été menée à partir d'un bain contenant 1,7 mole de CsCl, 1,5 mole de LiCl, 0,5 mole de NaCl et 2 moles de $YCl_3$, et que le Na contenu dans l'elpasolite effectivement cristallisée est à 80% sur les sites de type B et à 20% sur les sites de A, alors on peut décomposer virtuellement la 0,5 mole de Na dans le bain en 0,1 mole de NaCl de type ACl et 0,4 mole de NaCl de type BCl. Le bain contient donc 1,8 mole de ACl (1,7 mole de CsCl+0,1 mole de NaCl), 1,9 mole de BCl (1,5 mole de LiCl + 0,4 mole de NaCl) et 2 moles de $YCl_3$. Le rapport 2s/r est donc de 2,1.

Les composés porteurs de A, de B, de C, de M sont présents dans le bain fondu sous forme d'halogénure dont l'halogène correspond au X de la formule (1). Plusieurs halogènes X différents peuvent être présents dans le bain fondu si le cristal final doit contenir des halogènes X différents. Si t représente le nombre de mole en C dans le bain fondu, et si u représente le nombre de mole en M dans le bain fondu, alors, de préférence, le rapport 2(t+u)/r est compris dans le domaine allant de 0,8 à 1,2. De préférence, u/(t+u) est inférieur à 0,1. Notamment, u peut être nul.

L'elpasolite cristalline obtenue par le procédé selon l'invention peut être de formule réelle très proche de la stœchiométrie théorique. Cette formule réelle peut être représentée par la formule

$$A_aB_bC_cM_mX_x \hspace{4cm} (2)$$

dans laquelle A, B, C, M, X ont les significations précédemment données, et a, b, c, m et x représentent les fractions atomiques respectives des atomes A, B, C, M, X. Le rapport atomique 2b/a est compris dans le domaine allant de 0,97 à 1,4 (les bornes sont donc inclues dans le domaine), ce rapport 2b/a étant généralement inférieur à 1,2.

Le cristal selon l'invention est dans la majorité des cas de structure cristalline elpasolite cubique à faces centrées de groupe d'espace « $Fm\overline{3}m$ ». Avec la convention que la somme des fractions atomiques des cations (soit a+b+c+m) soit égale à 4, généralement, a est compris dans le domaine allant de 1,7 à 2,3 , b est compris dans le domaine allant de 0,8 à 1,2, c est compris dans le domaine allant de 0,85 à 1,1, m est compris dans le domaine allant de 0 à 0,05 et x est compris dans le domaine allant de 5,05 à 6,9.

Dans le procédé selon l'invention, l'excès en B est de préférence suffisant pour que le rapport du double de la fraction atomique en élément du type B sur la fraction atomique en élément du type A (donc le rapport 2b/a de la formule (2)) dans l'elpasolite effectivement réalisée soit d'au moins 0,97.

Dans les formules (1) et (2), A peut-être un mélange de plusieurs éléments choisis parmi Cs, Rb, K et Na. De même, B peut-être un mélange de plusieurs éléments choisis parmi Li, K ou Na. L'invention concerne plus particulièrement les cas où B comprend Li. Dans beaucoup de cas, B est simplement Li. De même, C peut-être un mélange de plusieurs éléments choisis parmi les terres rares (ce qui inclut Sc et Y), Al et Ga. De même, M peut-être un mélange de plusieurs éléments choisis parmi les alcalino-terreux, notamment un mélange de plusieurs éléments choisis parmi Ca, Mg, Sr ou Ba. Egalement, X peut-être un mélange de plusieurs éléments choisis parmi F, Cl, Br et I. L'invention concerne plus particulièrement les cas où X comprend Cl, Br et I.

L'invention concerne plus particulièrement les cas où A comprend Cs, B comprend Li et X comprend Cl ou Br. On s'intéresse plus particulièrement au deux cas suivant : 1) A comprend Cs, B comprend Li, C comprend La et X comprend Br ; 2) A comprend Cs, B comprend Li, C comprend Y et X comprend Cl.

La terre rare est un élément des Lanthanides de La à Lu, ou Sc ou Y (ces deux derniers éléments sont assimilés aux terres rares). L'invention concerne plus particulièrement les cas où C comprend une terre rare choisie parmi les Lanthanides de La à Lu, ou Y.

L'elpasolite est dopée par un élément activateur conférant ou améliorant son comportement de scintillation. L'élément activateur est au moins une terre rare choisie parmi Ce, Pr, Eu, Tb, Nd. Il peut s'agir d'un mélange d'activateurs, notamment Ce et Pr. L'élément activateur fait partie des éléments du type C. En général, l'activateur C" est présent avec une fraction atomique c" plus faible dans l'elpasolite qu'un autre élément C' également du type C, notamment Y, ledit élément C' étant présent avec la fraction atomique c'. Si C représente un mélange de deux éléments C' et C" (notamment respectivement Y et Ce), alors la fraction atomique c en élément du type C est telle que c=c'+c". La fraction atomique c" de l'élément activateur C" est telle que c"/(c+m) est supérieure à 0,00001 et inférieure ou égal à 0,1, c représentant la fraction atomique en élément C (ce qui inclut tous les éléments du type C, donc l'élément C') et m étant la fraction atomique en élément M. Les éléments C et M occupent les mêmes sites dans le réseau cristallin de l'elpasolite. L'elpasolite peut également contenir un mélange d'activateurs, notamment Ce et Pr. Dans ce cas, l'elpasolite contient trois éléments du type C (tous sur des sites du type C), C', C" et C''' (par exemple notamment respectivement Y, Ce, Pr), ce dernier élément étant présent avec la fraction atomique c'''. On a dans ce cas, (c"+c''')/(c+m) supérieure à 0,00001 et inférieure ou égal à 0,1.

La présence de M dans l'elpasolite, notamment Sr, modifie la viscosité, la température de fusion du mélange à fondre, l'émissivité dans l'infra-rouge du bain fondu et la tension de surface du bain fondu. La présence de M dans le cristal, notamment Sr, peut modifier ses propriétés de scintillation comme son rendement lumineux et sa résolution énergétique.

L'invention concerne les matériaux scintillateur de formule (1) et (2) ci-dessus pour lesquels B comprend Li, X comprend Cl, Br ou I, et C comprend une terre rare choisie parmi les Lanthanides de La à Lu, ou Y, et ce, le matériau scintillateur étant dopé par un élément activateur de sa scintillation. Les matériaux de formule (1) et (2) ci-dessus peuvent notamment être tels que B est Li, X est choisi parmi Cl, Br ou I, et C est choisi parmi les Lanthanides de La à Lu, ou Y, le matériau scintillateur étant dopé par un élément activateur de sa scintillation. Notamment, le matériau du lingot selon l'invention peut ne pas comprendre de fluor. Les matériaux scintillateurs réalisés selon l'invention peuvent avoir un rendement lumineux élevé, notamment mesuré avec une excitation gamma de 662 keV. Notamment, le rendement lumineux peut être supérieur à 15000 photons/MeV. Un matériau riche en $LaBr_3$, tel le CLLB, peut avoir un rendement lumineux supérieur à 25000 photons/MeV.

Les matériaux scintillateurs réalisés selon l'invention peuvent avoir une excellente résolution énergétique (faible largeur à mi-hauteur du pic de scintillation). Les mesures de scintillation peuvent été réalisées avec une source de rayons gamma de type $^{137}$Cs, un photomultiplicateur, une chaine de mesure standard. Les matériaux scintillateurs réalisés selon l'invention peuvent avoir une résolution énergétique inférieure à 6%, voire même inférieure à 5%, valeurs mesurées avec une source de rayons gamma [137]Cs. L'invention concerne plus particulièrement les cas où dans les formules (1) et (2) B comprend Li. L'invention concerne plus particulièrement les cas où dans les formules (1) et (2) A comprend Cs, et B comprend Li. L'invention concerne plus particulièrement les cas où dans les formules (1) et (2) A comprend Cs, B comprend Li et C comprend La. L'invention concerne plus particulièrement les cas où dans les formules (1) et (2) A comprend Cs, B comprend Li, C comprend La et X comprend Br, notamment X est à plus de 80% en mole Br (80% en mole de X est Br).

L'invention concerne plus particulièrement les cas où dans les formules (1) et (2) A comprend Cs, B comprend Li et C comprend Y. L'invention concerne plus particulièrement les cas où dans les formules (1) et (2) A comprend Cs, B comprend Li, C comprend Y et X comprend Cl, notamment X est à plus de 80% en mole de Cl (80% en mole de X est Cl).

L'elpasolite peut notamment être de composition théorique:

- $Cs_2LiYCl_6$ dopé ou non et notamment $Cs_2LiYCl_6$ :Ce, composé habituellement appelé « CLYC » par l'homme du métier ;
- $Cs_2LiLaBr_6$ dopé ou non et notamment $Cs_2LiLaBr_6$ :Ce composé habituellement appelé « CLLB » par l'homme du métier ;
- $Cs_2LiLaBr_{6(1-z)}Cl_{6z}$ avec z allant de 0 à 1, dopé ou non et notamment $Cs_2LiLaBr_{6(1-z)}Cl_{6z}$:Ce ;
- $Cs_2LiLaCl_6$ dopé ou non et notamment $Cs_2LiLaCl_6$ :Ce composé habituellement appelé « CLLC » par l'homme du métier ;
- $Cs_2LiYBr_6$ dopé ou non et notamment $Cs_2LiYBr_6$ :Ce composé habituellement appelé « CLYB » par l'homme du métier ;
- $Cs_{2(1-z)}Rb_{2z}LiTRX_6$ dopé ou non et notamment $Cs_{2(1-z)}Rb_{2z}LiTRX_6$ :Ce avec z allant de 0 à 1 ,TR représentant une terre rare ;
- $Rb_2LiYX_6$ dopé ou non et notamment $Rb_2LiYX_6$ :Ce ;
- $Cs_{2(1-z)}Rb_{2z}LiTRI_6$ avec z allant de 0 à 1 dopé ou non et notamment $Cs_{2(1-z)}Rb_{2z}LiTRI_6$:Ce , TR représentant une terre rare,
- $Cs_2LiY_{(1-x)}La_xCl_6$ dopé ou non et notamment $Cs_2LiY_{(1-x)}La_xCl_6$ :Ce .

Ainsi, le matériau scintillateur de structure de type elpasolite de composition théorique $A_2BC_{(1-y)}M_yX_{(6-y)}$ et de formule réelle $A_aB_bC_cM_mX_x$ pouvant être fabriqué par le procédé selon l'invention peut correspondre à l'un des cas ci-dessous :

- A est Cs, B est Li, C est un mélange de Y et Ce, et X est Cl ;
- A est Cs, B est Li, C est un mélange de La et Ce, et X est Br ;
- A est Cs, B est Li, C est un mélange de La et Ce, et X est Cl ;
- A est un mélange de Cs et Rb, B est Li, C est un mélange de La et Ce, et X est Br ;
- A est Cs, B est Li, C est un mélange de La et Ce, et X est un mélange de Cl et Br;
- A est Cs, B est Li, C est un mélange de Y et Ce, et X est un mélange de Cl et Br.
- A est Cs, B est Li, C est un mélange de La, Y et Ce, et X est Cl ;
- A est un mélange de Cs et Na, B est un mélange de Li et Na, C est un mélange de Y et Ce, et X est Cl.

Selon l'invention, une diminution sensible voire la suppression de la formation de phases parasites est obtenue en réalisant la cristallisation à partir d'un bain fondu de composition décalée par rapport à la composition du cristal final souhaitée dans la mesure où il contient un excès molaire en B par rapport à la stœchiométrie théorique du cristal. De plus, le rapport des fractions atomiques 2b/a (de la formule (2)) est plus proche du rapport stœchiométrique théorique de 1, voire même plus grand que 1.

La croissance est initiée à partir d'un bain fondu dont la composition ne correspond pas exactement à la composition stœchiométrique de l'elpasolite ni à la composition finale de l'elpasolite recherchée. Généralement, le procédé selon l'invention est du type « auto-flux », c'est-à-dire que le bain fondu ne contient pas d'élément chimique ne se retrouvant pas du tout dans le cristal. Si le liquide autour ou arrivant autour du cristal n'est pas de composition homogène, ce qui compte c'est que l'excès en B (c'est-à-dire 2s/r > 1,05) existe pour la partie du liquide en contact direct avec le cristal. En effet, la technique de croissance dite du « multi-creuset » selon laquelle au moins deux creusets se trouvent l'un dans l'autre peut être utilisée pour réaliser le procédé selon l'invention, dès lors que la composition liquide dans le creuset le plus intérieure et en contact avec le matériau cristallin vérifie la condition sur l'excès en B selon l'invention.

Le procédé selon l'invention prend généralement place dans un creuset ou une ampoule fermée voire scellée. Le creuset peut notamment être en graphite avec un revêtement pyrolytique, ou en carbone vitreux. L'ampoule fermée voire scellée est généralement en quartz ou en carbone vitreux ou en platine.

Selon l'invention, on procède en mettant les matières premières halogénées dans un contenant (creuset, ampoule, etc) sous atmosphère non-oxydante, puis on chauffe jusqu'à fusion des matières premières, puis on procède à la croissance cristalline selon la technique choisie (Bridgman, Czocharlski, etc) et on refroidit jusqu'à la température ambiante.

L'invention est menée pour aboutir à un monocristal en utilisant l'une des techniques connues de l'homme du métier comme celle de Czochralski ou Bridgman ou Bagdasarov (technique Bridgman horizontale) ou Kyropoulos ou encore la technique du « Vertical Gradient Freeze » ( cristallisation par contrôle de gradient thermique).

Le monocristal d'elpasolite peut avoir un volume supérieur à 10 cm$^3$ et même supérieur à 100 cm$^3$. Même si le lingot de croissance monocristalline contient des inclusions, la partie monocristalline exempt d'inclusion peut avoir un volume supérieur à 10 cm$^3$ et même supérieur à 100 cm$^3$.

Notamment, le procédé selon l'invention mène à un lingot dont les deux premiers tiers en volume de croissance du matériau monocristallin comprennent moins de 10% en volume de phase différente de celle de l'elpasolite, ce qui est remarquable. En particulier, dans le cas d'un procédé de croissance de monocristal du type Czochralski, les deux premiers tiers en volume de croissance du matériau monocristallin peuvent ne pas contenir de phase différente de celle de l'elpasolite, ce qui est également remarquable.

Les matières premières utilisées pour réaliser le bain fondu contiennent les éléments entrant dans la composition de l'elpasolite. Il peut par exemple s'agir d'un mélange d'un halogénure de A, d'un halogénure de B, d'un halogénure de C et d'un halogénure de M. Il suffit alors de charger un excès en halogénure de B par rapport à la composition stœchiométrique visée pour le cristal final. Pour le mélange de matières premières, il peut également s'agir d'un mélange de plusieurs halogénures dont au moins un comprend au moins deux des éléments A, B, C et M. Ici également, il suffit de charger un excès en l'halogénure contenant l'élément B, par rapport à la composition stœchiométrique visée.

Des exemples de composés pouvant servir à constituer un excès selon l'invention en Li sont LiCl, $Li_3YCl_6$, $Cs_3Li_2Cl_5$, $Cs_2Li_3Cl_5$, $Li3LaBr_6$.

Le procédé selon l'invention se traduit par une croissance cristalline comme conséquence d'un refroidissement contrôlé d'un bain d'une composition fondue. Cette composition fondue est obtenue par la fusion d'un composé ou d'un mélange de composés en tant que matière première (ce composé ou mélange de composés étant appelé précurseur) aboutissant à la composition souhaitée en les éléments souhaités au niveau du bain liquide. On peut utiliser un seul composé de composition correspondant exactement à celle du bain fondu souhaitée. On peut aussi utiliser comme matière première un mélange des halogénures des différents éléments entrant dans la composition souhaitée. Ainsi, si l'on souhaite fabriquer un CLYC, on peut mélanger un chlorure de Cs, un chlorure de Li, un chlorure de Y et, le cas échéant un chlorure de Ce (cas d'un dopage au Ce).

L'excès en B selon l'invention ne va pas totalement dans le matériau cristallin final, et ce qui n'y va pas peut être récupéré comme sous-produit après la solidification et réutilisé notamment dans le cadre du procédé selon l'invention. Si le procédé de croissance monocristalline Czochralski est utilisé, l'excès restant se retrouve dans la phase liquide restant dans le creuset. Si le procédé de croissance monocristalline Bridgman est utilisé, l'excès restant se trouve dans une zone comprenant des inclusions, ladite zone se formant principalement en fin de procédé et étant de toute façon en plus faible proportion qu'en l'absence d'excès.

L'excès en B selon l'invention peut permettre de rapprocher la composition du matériau cristallin final de la composition stœchiométrique parfaite $A_2BC_{(1-y)}M_yX_{(6-y)}$. Quand on réalise une cristallisation à partir d'un bain de composition correspondant exactement à celle du cristal d'elpasolite visé, le défaut stœchiométrique est de l'ordre de 2 à 3% en mole en B. Pour lutter contre ce déficit, l'invention propose d'utiliser un excès en B d'au moins 5% en mole (2s/r > 1,05).

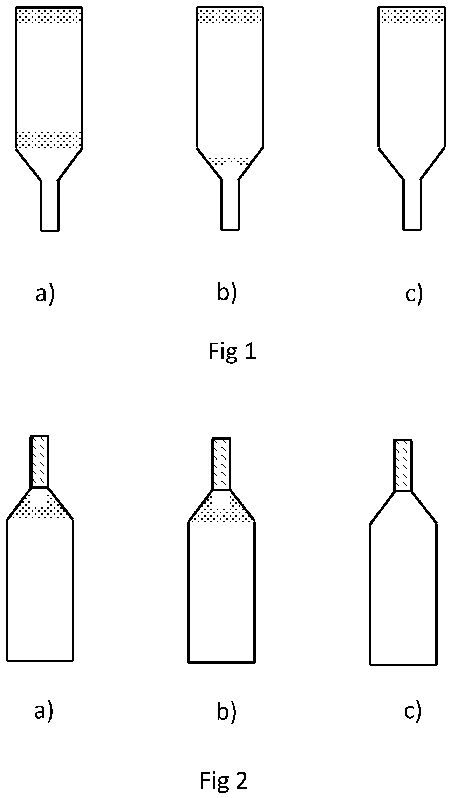

Pour une elpasolite donnée, il existe une valeur minimale en 2s/r au niveau du bain fondu pour laquelle les deux premiers tiers en volume de croissance du lingot sont entièrement (100%) composés de ladite elpasolite. Si l'on appelle t le nombre de moles en C dans le bain, alors, l'introduction dans le bain de matières premières telles que le rapport 2t/r supérieur à 1 et même supérieur à 1,08 et même supérieur à 1,1, voire même d'au moins 1,2, permet de réduire la valeur minimale en 2s/r pour laquelle les deux premiers tiers en volume de croissance sont entièrement (100% en volume) composés de ladite elpasolite. Pour un même volume d'elpasolite utilisable dans les deux premiers tiers du lingot fabriqué, l'augmentation du rapport 2t/r permet de réduire le rapport 2s/r. L'augmentation du rapport 2t/r peut être réalisée en introduisant dans le bain fondu notamment des composés du type $B_3CX_6$ (B, C et X ayant les significations précédemment données) comme $Li_3LaBr_6$ ou $Li_3YCl_6$. On pourrait également réaliser cet excès en C par une quantité plus élevée en $CX_3$. Cependant, l'utilisation de composés du type $B_3CX_6$ permet de réaliser un excès à la fois en B et en C. Cet effet du fort rapport 2t/r sur la qualité du lingot est particulièrement notable dans le cas des elpasolites pour lesquelles C est à plus de 80% en mole le Lanthane et X est à plus de 80% en mole le Brome (elpasolithe « riches en $LaBr_3$ »). Si le 2t/r est plus fort, le rendement en cristal parfait est amélioré, notamment au-delà des deux premiers tiers en volume de croissance. Dans le cas d'une croissance Bridgman, on diminue la quantité de matière impropre en fin de croissance (partie grisée de la figure 1c notamment). Dans le cas d'une croissance Czochralski, on laisse moins de matière dans le bain quand la croissance est terminée. Augmenter le 2t/r permet même de réduire le 2s/r, par exemple à moins de 1,65.

Pour le cas d'une elpasolite pour laquelle C comprend La, notamment si C est à plus de 80% en mole le Lanthane et pour laquelle X comprend Br, notamment si X est à plus de 80% en mole le Brome, notamment dans le cas d'une elpasolite du type CLLB, alors, le fait d'avoir à la fois 2t/r supérieur à 1 et même supérieur à 1,08 et même supérieur à 1,1, voire même d'au moins 1,2 , en concomitance avec le fait d'avoir 2s/r supérieur à 1,05, voire même d'au moins 1,1 permet d'obtenir un 2b/a d'au moins 1,1, voire même d'au moins 1,15 voire même d'au moins 1,2, notamment jusqu'à 1,4.

Les elpasolites d'halogénure de terre rare sont généralement hygroscopiques et doivent être manipulées sous atmosphère adaptée, c'est-à-dire sèche et neutre ou réductrice (azote hydrogéné, argon, azote, argon hydrogéné) ou sous vide. Ceci vaut aussi pour les techniques de mesure utilisées qui doivent être réalisées en atmosphère adaptée, notamment les mesures en diffraction. Des mesures de diffraction faites en atmosphère non-adaptée (à l'air ambiant notamment) peuvent complètement fausser les mesures. Le procédé Bridgman pouvant faire intervenir une cristallisation en ampoule scellée sous vide (généralement en quartz ou en carbone vitreux) est avantageux de ce point de vue, car la cristallisation est facilement réalisée en atmosphère adaptée.

La température à laquelle le bain fondu est porté avant cristallisation dépend de la formulation du bain. En général, le bain est porté entre 400 et 1100°C selon la composition, avant cristallisation. Dans le cadre d'un procédé de croissance monocristalline, les vitesses de refroidissement sont en générale comprises entre 0,01 °C/heure et 5°C/heure. En procédé Bridgman, la vitesse de translation du cristal est généralement comprise entre 0,01 mm/h et 20 mm/h. Si l'on cherche à obtenir un polycristal de la phase elpasolite, les vitesses de refroidissement peuvent être bien plus rapides, notamment comprises entre 5 et 200°/h.

La figure 1 représente des lingots sortis de leur ampoule après croissance cristalline du type Bridgman. Le cas a) correspond à ce que l'on obtient selon l'art antérieur, c'est-à-dire un fort taux volumique de lingot inutilisable car comprenant beaucoup d'inclusions (parties grisées), notamment au début de la croissance, ce qui correspond à la partie inférieure du lingot. Cette partie étroite du lingot est prise en compte pour l'expression du résultat et compte donc comme volume de croissance selon l'invention. Le cas c) correspond au cas selon l'invention avec un fort taux de monocristal utilisable. La partie grisée en haut correspond à une phase non désirée. Le cas b) correspond à une situation intermédiaire avec un excès en B inférieur à celui utilisé en c), ce qui a mené à un taux d'inclusions plus élevé.

La figure 2 représente des lingots après croissance cristalline du type Czochralski. La partie étroite en zone supérieure correspond au germe monocristallin utilisé pour initier la croissance. Cette partie n'est pas prise en compte pour l'expression du résultat. En a), le lingot est totalement inutilisable car entièrement pollué par des inclusions et correspond à l'art antérieur, c'est-à-dire une absence d'excès en B. En c), le lingot est parfait, dénué d'inclusions. Un excès en B selon l'invention a été utilisé. Le cas b) correspond à un cas intermédiaire aux cas a) et c), avec un excès en B inférieur à celui utilisé c).

## EXEMPLES

On réalise des mélanges de poudres de matières premières du type halogénures des cations à insérer dans l'elpasolite.

On réalise des monocristaux par cristallisation à partir de bains fondus dont les compositions sont rapportées dans le tableau 1. Les exemples sont selon l'invention ou sont comparatifs et comportent dans ce dernier cas la mention « comp ». La composition du bain peut être exprimée globalement où en la présentant sous la forme de la somme d'une elpasolite stœchiométrique et du ou des composés mis en excès comprenant B. Dans ce tableau, BG signifie que l'on a exercé une croissance du type Bridgman et CZ signifie que l'on a exercé une croissance du type Czochralski. Dans le cas de l'exemple 8, le sodium pouvant aller sur les sites du Cs ou du Li, on a constaté à postériori que dans le cristal final la proportion de Na sur les sites de Li était de 89% et la proportion de Na sur les sites de Cs était de 11%. C'est pourquoi, pour 2 moles de Cs introduits dans le bain, la quantité de A dans le bain est de 2 (pour le Cs) + 0,074 (pour 11% de 0,67 mole de Na) soit 2,074 moles. La quantité de B dans le bain est de 1 (pour le Li) + 0,596 (pour 89% de 0,67 mole de Na) soit 1,596 mole. Le rapport 2s/r est donc ici de (2x1,596)/2,074=1,54.

Dans le cas d'une croissance du type CZ, tout le bain engagé n'est pas transformé en matière du lingot, de façon inhérente à cette technique. Au contraire, en cristallisation Bridgman, tout le bain engagé est solidifié dans le lingot. Dans la dernière colonne du tableau 1, on donne le pourcentage de monocristal véritablement utilisable dans les deux premiers tiers de croissance du lingot solidifié. Il ne s'agit donc pas en croissance CZ d'un pourcentage de la matière engagée dans le bain. Par contre, en croissance Bridgman, il s'agit aussi d'un pourcentage de la matière engagée dans le bain. Les exemples 20, 21, 22, 24 montrent dans le cas de CLLB qu'un fort rapport 2s/r dans le bain mène à un 2b/a nettement supérieur à 1 dans l'elpasolite.

Tableau 1

| Ex n° | Type de croiss. | Composition bain fondu | 2s/r bain | 2t/r bain | Composition cristal obtenu | 2b/a cristal final | % vol utilisable 2 premiers 1/3 lingot |
|---|---|---|---|---|---|---|---|
| 1 (comp) | BG | $Cs_2Li_1Y_{0,995}Cl_6:Ce_{0,0005}$ | 1 | 1 | $Cs_{2,035}Li_{0,982}Y_{0,982}Cl_{5,966}:Ce_{0,001}$ | 0,965 | 84 |
| 2 (comp) | BG | $Cs_2Li_1Y_1Cl_6$ | 1 | 1 | $Cs_{2,046}Li_{0,972}Y_{0,982}Cl_{5,964}$ | 0,95 | 82 |
| 3 (comp) | CZ | $Cs_2Li_1Y_1Cl_6$ | 1 | 1 | - | | 0 |
| 4 | CZ | $Cs_2Li_{1,67}Y_{0,995}Cl_{6,67}:Ce_{0,005}$ soit $Cs_2Li_1Y_{0,995}Cl_6:Ce_{0,005}$ + 0,67 LiCl | 1,67 | 1 | $Cs_{1,997}Li_{0,998}Y_{1,004}Cl_{6,01}:Ce_{0,001}$ | 0,999 | 100 |
| 5 | BG | $Cs_2Li_{1,249}Y_{1,078}Cl_{6,489}:Ce_{0,005}$ soit $Cs_2Li_1Y_{0,995}Cl_6:Ce_{0,005}$ + 0,083 $Li_3YCl_6$ | 1,25 | 1,083 | $Cs_{2,015}Li_{0,996}Y_{0,988}Cl_{5,978}:Ce_{0,001}$ | 0,989 | 100 |
| 6 | BG | $Cs_2Li_{1,56}Y_{0,995}La_{0,1}Ce_{0,005}Cl_{6,86}$ soit $Cs_2Li_1Y_{0,995}Cl_6:Ce_{0,005}$ + 0,56 LiCl + 0,1 $LaCl_3$ | 1,56 | 1,1 | $Cs_{2,006}Li_{0,995}La_{0,008}Y_{0,989}Cl_{5,998}:Ce_{0,002}$ | 0,992 | 100 |
| 7 | BG | $Cs_2Li_{1,66}Y_{0,995}Cl_{6,66}:Ce_{0,005}$ soit $Cs_2Li_1Y_{0,995}Cl_6:Ce_{0,005}$ + 0,66 LiCl | 1,66 | 1 | $Cs_{2,005}Li_{0,995}Y_{0,999}Cl_{5,74}:Ce_{0,001}$ | 0,993 | 100 |
| 8 | BG | $Cs_2Li_1 Na_{0,67} Y_{0,995} Ce_{0,006} Cl_{6,67}$ soit $Cs_2Li_1 Ce_{0,005}Y_{0,995}Cl_6$ + 0,67 NaCl | 1,67 | 1 | $Cs_{1,91}Li_{0,467}Na_{0,599}Y_{1,022}Cl_{6,048}:Ce_{0,002}$ soit $(Cs_{1,91}Na_{0,066})(Li_{0,467}Na_{0,533})(Y_{1,022}Ce_{0,002})Cl_{6,048}$ | 1,012 | 100 |
| 9 | CZ | $Cs_2Li_{1,67}Y_{0,995}Ca_{0,003}Ce_{0,005}Cl_{6,676}$ Soit $Cs_2LiY_{0,995}Ce_{0,005}Cl_6$ + 0,67LiCl + 0,003 $CaCl_2$ | 1,67 | 1 | $Cs_{2,018}Li_{1,006}Ca_{0,001}Y_{0,974}Cl_{5,951}:Ce_{0,001}$ | 0,997 | 100 |
| 10 | BG | $Cs_2Li_{1,67}Y_{0,995}Sr_{0,003}Ce_{0,005}Cl_{6,676}$ soit $Cs_2LiY_{0,995}Ce_{0,005}Cl_6$ + 0,67LiCl + 0,003 $SrCl_2$ | 1,67 | 1 | $Cs_{2,005}Li_{1,071}Sr_{0,001}Y_{0,921}Cl_{5,847}:Ce_{0,002}$ | 1,068 | 100 |
| 11 (comp) | CZ | $Cs_2LiLa_{0,98}Ce_{0,02}Br_6$ | 1 | 1 | - | | 0 |
| 12 | CZ | $Cs_2Li_{1,8}La_{0,99}Ce_{0,01}Br_{6,8}$ Soit $Cs_2Li_1La_{0,99}Ce_{0,01}Br_6$ + 0,8 LiBr | 1,8 | 1 | $Cs_{2,009}Li_{1,01}La_{0,98}Br_{5,97}:Ce_{0,001}$ | 1,005 | 100 |
| 13 (comp) | BG | $Cs_2Li_1Y_{0,995}Ce_{0,005}Br_6$ | 1 | 1 | $Cs_{2,025}Li_{0,978}Y_{0,995}Br_{5,994}:Ce_{0,002}$ | 0,966 | 100 |
| 14 | BG | $Cs_2Li_{1,1}Y_{0,995}Ce_{0,005}Br_6$ Soit $Cs_2Li_1Y_{0,995}Ce_{0,005}Br_6$ + 0,1 LiBr | 1,1 | 1 | $Cs_{2,001}Li_{1,006}Y_{0,991}Br_6:Ce_{0,002}$ | 1,005 | 100 |
| 15 (comp) | BG | $Rb_2LiY_{0,99}Ce_{0,01}Br_6$ | 1 | 1 | $Rb_{2,027}Li_{0,976}Y_{0,996} Br_{5,994}:Ce_{0,001}$ | 0,963 | 76 |
| 16 | BG | $Rb_2Li_{1,7}Y_{0,99}Ce_{0,01}Br_{6,7}$ soit $Rb_2LiY_{0,99}Ce_{0,01}Br_6$ + 0,7 LiBr | 1,7 | 1 | $Rb_{2,005}Li_{1,005}Y_{0,989}Br_{5,98}:Ce_{0,001}$ | 1,002 | 92 |

| Ex n° | Type de croiss. | Composition bain fondu | 2s/r bain | 2t/r bain | Composition cristal obtenu | 2b/a cristal final | % vol utilisable 2 premiers 1/3 lingot |
|---|---|---|---|---|---|---|---|
| 17 (hors invention) | BG | $Cs_2Li_{1,60}Y_{0,9965}F_{6,6}:Ce_{0,0035}$ | 1,6 | 1 | $Cs_{1,994}Li_{0,997}Y_{1,007}F_{6,018}:Ce_{0,002}$ | 1,017 | 100 |
| 18 | CZ | $Cs_2Li_{1,6}La_{0,98}Ce_{0,02}Br_6Cl_{0,6}$ Soit $Cs_2Li_1La_{0,98}Ce_{0,02}Br_6$ + 0,6 LiCl | 1,6 | 1 | $Cs_{1,961}Li_{1,051}La_{0,987}Br_{5,976}Cl_{0,051}:Ce_{0,001}$ | 1,072 | 100 |
| 19 | CZ | $Cs_2Li_{1,6}Y_{1,195}Cl_{7,2}:Ce_{0,005}$ soit $Cs_2Li_1Y_{0,995}Cl_6:Ce_{0,005}$ + 0,2 $Li_3YCl_6$ | 1,6 | 1,2 | $Cs_2Li_{1,001}Y_{0,998}Cl_{5,998}:Ce_{0,001}$ | 1,001 | 100 |
| 20 | BG | $Cs_2Li_{1,36}La_{1,118}Ce_{0,002}Br_{6,72}$ Soit $Cs_2Li_1La_{0,998}Ce_{0,002}Br_6$+ 0,12 $Li_3LaBr_6$ | 1,36 | 1,12 | $Cs_{1,884}Li_{1,113}La_{0,972}Ce_{0,031}Br_{6,006}$ | 1,181 | 100 |
| 21 | BG | $Cs_2Li_{1,5}La_{1,13}Ce_{0,02}Br_{6,9}I_{0,05}$ Soit $Cs_2Li_1La_{0,98}Ce_{0,02}Br_6$ + 0,15 $Li_3LaBr_6$ + 0,05 LiI | 1,5 | 1,15 | $Cs_{1,842}Li_{1,133}La_{0,996}Ce_{0,029}Br_{5,53}I_{0,52}$ | 1,23 | 100 |
| 22 | BG | $Cs_2Li_{1,5}La_{1,13}Ce_{0,02}Br_{6,95}$ Soit $Cs_2Li_1La_{0,98}Ce_{0,02}Br_6$ + 0,15 $Li_3LaBr_6$ + 0,05 LiBr | 1,5 | 1,15 | $Cs_{1,842}Li_{1,124}La_{1,004}Ce_{0,03}Br_{6,068}$ | 1,22 | 100 |
| 24 | BG | $Cs_2Li_{1,5}La_{1,08}Ce_{0,02}Br_{6,8}$ Soit $Cs_2Li_1La_{0,98}Ce_{0,02}Br_6$ + 0,1 $Li_3LaBr_6$ + 0,2 LiBr | 1,5 | 1,1 | $Cs_{1,861}Li_{1,132}La_{0,976}Ce_{0,031}Br_{6,014}$ | 1,22 | 100 |
| 25 | BG | $Cs_2Li_{1,55}Y_{1,098}Ce_{0,002}Cl_{6,85}$ | 1,55 | 1,1 | $Cs_{1,991}Li_{1,047}Y_{0,930}Ce_{0,032}Cl_{5,924}$ | 1,05 | 100 |
| | | Soit $Cs_2Li_1Y_{0,998}Ce_{0,002}Cl_6$ + 0,1 $Li_3YCl_6$ + 0,25 LiCl | | | | | |
| 26 | BG | $Cs_2Li_{1,453}Y_{1,148}Ce_{0,002}Sr_{0,003}Cl_{6,906}$ Soit $Cs_2Li_1Y_{0,998}Ce_{0,002}Cl_6$ + 0,15 $Li_3YCl_6$ + 0,003 $SrCl_2$ | 1,45 | 1,15 | $Cs_{1,98}Li_{1,026}Sr_{0,001}Y_{0,992}Ce_{0,001}Cl_{5,988}$ | 1,04 | 100 |
| 27 | BG | $Cs_2Li_{1,45}Y_{1,148}Ce_{0,002}Cl_{6,9}$ Soit $Cs_3LiY_{0,998}Ce_{0,002}Cl_6$ + 0,15 $Li_3YCl_6$, | 1,45 | 1,15 | $Cs_{1,944}Li_{1,054}Y_{1,001}Ce_{0,001}Cl_{6,004}$ | 1,08 | 100 |
| 28 | CZ | $Cs_2Li_{1,3}Y_{1,098}Ce_{0,002}Cl_{6,6}$ Soit $Cs_3Li_1Y_{0,998}Ce_{0,002}Cl_6$ + 0,1 $Li_3YCl_6$, | 1,3 | 1,1 | $Cs_{2,041}Li_1Y_{0,958}Ce_{0,001}Cl_{5,918}$ | 0,98 | 100 |

Le tableau 2 donne les propriétés de scintillation de certains cristaux déjà décrit dans le tableau 1. On y indique le rendement lumineux relatif (colonne LO pour « light output ») mesuré avec une excitation gamma de 662 keV et la résolution énergétique (largeur à mi-hauteur du pic de scintillation). Les mesures de scintillation ont été réalisées avec une source de rayons gamma de type $^{137}$Cs, un photomultiplicateur, une chaine de mesure standard. Les valeurs obtenues sont comparables entre elles car déterminées avec une géométrie d'échantillon déterminée et avec les mêmes instruments de mesure. Plus la valeur de résolution énergétique est basse, meilleure elle est. Le rendement lumineux est de préférence le plus fort possible. Pour les cristaux du type CLYC, on a exprimé le rendement lumineux relativement à celui de l'exemple 1 (LO évalué à 1 arbitrairement). Pour les cristaux du type CLLB, on a exprimé le rendement lumineux relativement à celui de l'exemple 11 (LO évalué à 1 arbitrairement).

Tableau 2

|  | LO relatif | Résolution énergétique |
|---|---|---|
| CLYC ex 1 (référence) | 1 | 6,19% |
| CLYC ex 4 | 1,15 | 4,61% |
|  |  |  |
| CLYC ex 5 | 1,28 | 5,15% |
| CLYC ex 7 | 1,20 | 4,67% |
| CLLB ex 11 (référence) | 1 | 8,73% |
| CLLB ex 12 | 1,20 | 4,14% |

Les figures 1a) et 1c) représentent des ampoules après croissance cristalline du type Bridgman selon les exemples. Les exemples 1, 2 et 15 aboutissaient à un lingot du type de celui de la figure 1a). Les exemples 5, 6, 7, 8, 10, 13, 14 et 17 aboutissaient à un lingot du type de celui de la figure 1c). Pour ces exemples 5, 6, 7, 8, 10, 13, 14, 17 les deux premiers tiers en volume de croissance du matériau monocristallin comprennent moins de 10% en volume de phase différente de celle de l'elpasolite Dans ces cas spécifiques, le volume de phase impure est à 0%.

Dans le cas des exemples 15 et 16, on montre que les deux premiers tiers en volume de phase différente de la phase elpasolite peuvent être abaissés de 24% à 8% grâce à l'invention. L'exemple 16 aboutis donc à un lingot du type de la figure 1b) ou les deux premiers tiers en volume de croissance du matériau monocristallin comprennent moins de 10% en volume de phase différente de celle de l'elpasolite mais plus que 0%.

Les figures 2a) et 2c) représentent des lingots après croissance cristalline du type Czochralski selon les exemples. Les exemples 3 et 11 aboutissaient à un lingot du type de celui de la figure 2a). Les exemples 4, 9, 12, 18 et 19 aboutissaient à un lingot du type de celui de la figure 2c). Pour ces exemples 4, 9 et 12, 18, et 19 les 100% en volume de croissance du matériau monocristallin ne contiennent pas de phase différente de celle de l'elpasolite.

On voit bien que les exemples selon l'invention utilisant un excès en B (soit 2s/r > 1) donnent lieu à beaucoup moins d'inclusions et donc à un meilleur rendement de fabrication en monocristal. Ils donnent également lieu à de meilleures performances en scintillation.

Dans le cas des exemples 5, 6, 19, 20, 21, 22, 24, 25, 26, 27, 28, le 2t/r dans le bain était supérieur à 1 et le 2s/r dans le bain était supérieur à 1,08. Dans ces cas, on a observé une croissance correspondant, selon son type, aux figures 1c ou 2c, le rendement en cristal parfait étant augmenté. Dans le cas d'une croissance Bridgman, c'est la partie grisée de la figure 1c qui était réduite. Dans le cas d'une croissance Czochralski, c'est la quantité de matière restant dans le bain qui était réduite. On a mesuré dans le cas des exemples 7 et 27 le pourcentage de la masse de la phase parasite en fin de croissance (partie grisée de la figure 1c) sur la masse totale de matière introduite dans l'ampoule Brigman. On a constaté que ce pourcentage est nettement inférieur dans le cas de l'exemple 27 (10%) par rapport à celui de l'exemple 7 (17,9%). Le rendement matière est bien plus fort dans le cas de l'exemple 27 comparé à l'exemple 7.

## Revendications

1. Procédé de croissance monocristalline pour la fabrication d'un matériau cristallin scintillateur de structure de type elpasolite de composition théorique $A_2BC_{(1-y)}M_yX_{(6-y)}$, ledit matériau cristallin étant à fusion non congruente, dans laquelle

    - A est choisi parmi Cs, Rb, K, Na,
    - B est choisi parmi Li, K, Na, et comprend Li,

- C est choisi parmi les terres rares, Al, Ga, et comprend une terre rare choisie parmi les Lanthanides de La à Lu, ou Y,
- M est choisi parmi les alcalino-terreux,
- X est choisi parmi F, Cl, Br, I, et comprend Cl, Br ou I,

y représentant la fraction atomique de substitution de C par M et étant compris dans le domaine allant de 0 à 0,05 , comprenant sa cristallisation par refroidissement à partir d'un bain fondu comprenant r moles de A et s moles de B, **caractérisé en ce que** le matériau cristallin scintillateur est dopé par un élément activateur de sa scintillation et **en ce que** le bain fondu en contact avec le matériau contient A et B de sorte que 2s/r soit supérieur à 1,05, ledit procédé utilisant une technique choisie parmi celles de Czochralski, Bridgman, Bagdasarov, Kyropoulos et la technique du Vertical Gradient Freeze.

2. Procédé selon la revendication précédente, **caractérisé en ce que** 2s/r est supérieur à 1,15 et de préférence supérieur à 1,25 et de préférence supérieur à 1,35 et de préférence supérieur à 1,5.

3. Procédé selon l'une des revendications précédentes, **caractérisé en ce que** 2s/r est inférieur à 10 et de préférence inférieur à 5 et de préférence inférieur à 3.

4. Procédé selon l'une des revendications précédentes, **caractérisé en ce que** 2s/r est suffisant pour que le rapport du double de la fraction atomique en élément du type B sur la fraction atomique en élément du type A dans le matériau cristallin soit d'au moins 0,97.

5. Procédé selon l'une des revendications précédentes, **caractérisé en ce que** M est choisi parmi Ca, Mg, Sr ou Ba.

6. Procédé selon l'une des revendications précédentes, **caractérisé en ce que** C comprend au moins une terre rare activateur choisie parmi Ce, Pr, Eu, Tb, Nd, dont la fraction atomique est telle que le rapport de sa fraction atomique sur la somme des fractions atomiques en élément C et M dans le matériau cristallin est supérieure à 0,00001 et inférieure ou égale à 0,1.

7. Procédé selon l'une des revendications précédentes, **caractérisé en ce que** 2s/r est insuffisant pour générer la formation d'une phase de $B_3C_{(1-y)}M_yX_6$ en début de cristallisation.

8. Procédé selon l'une des revendications précédentes, **caractérisé en ce que** B est Li.

9. Procédé selon l'une des revendications précédentes, **caractérisé en ce que** A comprend Cs.

10. Procédé selon la revendication précédente, **caractérisé en ce que** C comprend La et X comprend Br.

11. Procédé selon l'une des deux revendications précédentes, **caractérisé en ce que** C est à plus de 80% en mole le Lanthane et X est à plus de 80% en mole le Brome.

12. Procédé selon la revendication 11, **caractérisé en ce que** C comprend Y, notamment C est à plus de 80% en mole Y, et X comprend Cl, notamment X est à plus de 80% en mole Cl.

13. Procédé selon l'une des revendications précédentes, **caractérisé en ce que** 2t/r est supérieur à 1, et même supérieur à 1,1 et même d'au moins 1,2 , t représentant le nombre de moles en C dans le bain.

14. Procédé selon l'une des revendications 1 à 10, **caractérisé en ce que** 2t/r est supérieur à 1, et même supérieur à 1,1 et même d'au moins 1,2 , t représentant le nombre de moles en C dans le bain, C comprend La notamment C est à plus de 80% en mole La, et X comprend Br notamment X est à plus de 80% en mole Br, et 2s/r est supérieur à 1,05, voire même d'au moins 1,1.

15. Procédé selon l'une des revendications précédentes **caractérisé en ce qu'**il est un procédé de croissance monocristalline choisi parmi celui de Bridgman ou de Czochralski.

16. Procédé selon la revendication précédente, **caractérisé en ce que** les deux premiers tiers en volume de croissance du matériau monocristallin comprennent moins de 10% en volume de phase différente de celle de l'elpasolite.

**17.** Procédé selon la revendication précédente, **caractérisé en ce que** la cristallisation est du type Czochralski et **en ce que** les deux premiers tiers en volume de croissance du matériau monocristallin ne contiennent pas de phase différente de celle de l'elpasolite.

**18.** Lingot de croissance monocristalline comprenant un matériau monocristallin scintillateur dopé par un élément activateur de sa scintillation obtenu par un procédé selon l'une des revendications précédentes, de structure de type elpasolite de composition théorique $A_2BC_{(1-y)}M_yX_{(6-y)}$ et de formule réelle $A_aB_bC_cM_mX_x$ dans laquelle

- A est choisi parmi Cs, Rb, K, Na,
- B est choisi parmi Li, K, Na, et comprend Li,
- C est choisi parmi les terres rares, Al, Ga, et comprend une terre rare choisie parmi les Lanthanides de La à Lu, ou Y,
- M est choisi parmi les alcalino-terreux,
- X est choisi parmi F, Cl, Br, I, et comprend Cl, Br ou I,

y représentant la fraction atomique de substitution de C par M, et étant compris dans le domaine allant de 0 à 0,05 , a, b, c, m, x représentant les fractions atomiques respectives en A, B, C, M, X, le rapport 2b/a étant compris dans le domaine allant de 0,97 à 1,4, les deux premiers tiers en volume de croissance dudit lingot comprenant moins de 10% en volume de phase différente de celle du matériau elpasolite, voire ne contenant pas de phase différente de celle du matériau elpasolite.

**19.** Lingot selon la revendication précédente, **caractérisé en ce que** C contient au moins une terre rare activateur choisie parmi Ce, Pr, Eu, Tb, Nd, dont la fraction atomique est telle que le rapport de sa fraction atomique sur la somme des fractions atomiques en élément C et M est supérieure à 0,00001 et inférieur ou égal à 0,1.

**20.** Lingot selon l'une des revendications de matériau précédentes, **caractérisé en ce que** A comprend Cs.

**21.** Lingot selon la revendication précédente, **caractérisé en ce que** C comprend La, notamment C est à plus de 80% en mole le Lanthane et X comprend Br, notamment X est à plus de 80% en mole le Brome.

**22.** Lingot selon l'une des revendications 18 à 20, **caractérisé en ce que** C comprend Y, notamment C est à plus de 80% en mole Y, et X comprend Cl, notamment X est à plus de 80% en mole Cl.

**23.** Lingot selon l'une des revendications 18 et 19, **caractérisé en ce que** A est Cs, B est Li, C est un mélange de Y et Ce, et X est Cl.

**24.** Lingot selon l'une des revendications 18 et 19, **caractérisé en ce que** A est Cs, B est Li, C est un mélange de La et Ce, et X est Br.

**25.** Lingot selon l'une des revendications 18 et 19, **caractérisé en ce que** A est Cs, B est Li, C est un mélange de La et Ce, et X est Cl.

**26.** Lingot selon l'une des revendications 18 et 19, **caractérisé en ce que** A est un mélange de Cs et Rb, B est Li, C est un mélange de La et Ce, et X est Br.

**27.** Lingot selon l'une des revendications 18 et 19, **caractérisé en ce que** A est Cs, B est Li, C est un mélange de La et Ce, et X est un mélange de Cl et Br.

**28.** Lingot selon l'une des revendications 18 et 19, **caractérisé en ce que** A est Cs, B est Li, C est un mélange de Y et Ce, et X est un mélange de Cl et Br.

**29.** Lingot selon l'une des revendications 18 et 19, **caractérisé en ce que** A est Cs, B est Li, C est un mélange de La, Y et Ce, et X est Cl.

**30.** Lingot selon l'une des revendications 18 et 19, **caractérisé en ce que** A est un mélange de Cs et Na, B est un mélange de Li et Na, C est un mélange de Y et Ce et X est Cl.

**31.** Lingot selon l'une des revendications 21 ou 27 **caractérisé en ce que** le rapport 2b/a est compris dans le domaine allant de 1,1 à 1,4.

**32.** Lingot selon l'une des revendications de matériau précédentes, **caractérisé en ce que** sa résolution énergétique de scintillation est inférieure à 6%, voire même inférieure à 5%, mesurée avec une source de rayons gamma $^{137}$Cs de 662keV.

**Patentansprüche**

**1.** Einkristallzuchtverfahren zur Herstellung eines kristallinen Szintillatormaterials mit Struktur vom Typ Elpasolith mit der theoretischen Zusammensetzung $A_2BC_{(1-y)}M_yX_{(6-y)}$, wobei das kristalline Material nicht kongruent schmelzend ist, wobei

- A aus Cs, Rb, K, Na ausgewählt ist,
- B aus Li, K, Na ausgewählt ist und Li umfasst,
- C aus Seltenen Erden, Al, Ga ausgewählt ist und eine Seltene Erde umfasst, die aus den Lanthaniden von La bis Lu oder Y ausgewählt ist,
- M aus Erdalkalien ausgewählt ist,
- X aus F, Cl, Br, I ausgewählt ist und Cl, Br oder I umfasst,

wobei y den atomaren Anteil der Substitution von C durch M darstellt und im Bereich von 0 bis 0,05 liegt, umfassend seine Kristallisation durch Abkühlen aus einem Schmelzbad, das r Mol A und s Mol B enthält, **dadurch gekennzeichnet, dass** das kristalline Szintillationsmaterial mit einem seine Szintillation aktivierenden Element dotiert ist, und **dass** das mit dem Material in Kontakt stehende Schmelzbad A und B enthält, so dass 2s/r größer als 1,05 ist, wobei das Verfahren eine Technik verwendet, die aus den Techniken von Czochralski, Bridgman, Bagdasarov, Kyropoulos und der Vertical Gradient Freeze-Technik ausgewählt ist.

**2.** Verfahren nach vorstehendem Anspruch, **dadurch gekennzeichnet, dass** 2s/r größer als 1,15 und vorzugsweise größer als 1,25 und vorzugsweise größer als 1,35 und vorzugsweise größer als 1,5 ist.

**3.** Verfahren nach einem der vorstehenden Ansprüche, **dadurch gekennzeichnet, dass** 2s/r kleiner als 10 und vorzugsweise kleiner als 5 und vorzugsweise kleiner als 3 ist.

**4.** Verfahren nach einem der vorstehenden Ansprüche, **dadurch gekennzeichnet, dass** 2s/r ausreichend ist, damit das Verhältnis des doppelten atomaren Anteils an Elementen vom Typ B zum atomaren Anteil an Elementen vom Typ A im kristallinen Material mindestens 0,97 beträgt.

**5.** Verfahren nach einem der vorstehenden Ansprüche, **dadurch gekennzeichnet, dass** M aus Ca, Mg, Sr oder Ba ausgewählt ist.

**6.** Verfahren nach einem der vorstehenden Ansprüche, **dadurch gekennzeichnet, dass** C mindestens eine aktivierende Seltene Erde, ausgewählt aus Ce, Pr, Eu, Tb, Nd, umfasst, deren atomarer Anteil so bemessen ist, dass das Verhältnis ihres atomaren Anteils zur Summe der atomaren Anteile an Element C und M im kristallinen Material größer als 0,00001 und kleiner als oder gleich 0,1 ist.

**7.** Verfahren nach einem der vorstehenden Ansprüche, **dadurch gekennzeichnet, dass** 2s/r nicht ausreicht, um die Bildung einer $B_3C_{(1-y)}M_yX_6$-Phase zu Beginn der Kristallisation zu erzeugen.

**8.** Verfahren nach einem der vorstehenden Ansprüche, **dadurch gekennzeichnet, dass** B Li ist.

**9.** Verfahren nach einem der vorstehenden Ansprüche, **dadurch gekennzeichnet, dass** A Cs umfasst.

**10.** Verfahren nach vorstehendem Anspruch, **dadurch gekennzeichnet, dass** C La und X Br umfasst.

**11.** Verfahren nach einem der vorstehenden Ansprüche, **dadurch gekennzeichnet, dass** C zu mehr als 80 Mol-% aus Lanthan und X zu mehr als 80 Mol-% aus Brom besteht.

**12.** Verfahren nach Anspruch 11, **dadurch gekennzeichnet, dass** C Y umfasst, C insbesondere zu mehr als 80 Mol-% Y ist und X Cl umfasst, X insbesondere zu mehr als 80 Mol-% Cl ist.

13. Verfahren nach einem der vorstehenden Ansprüche, **dadurch gekennzeichnet, dass** 2t/r größer als 1 oder sogar größer als 1,1 oder sogar mindestens 1,2 ist, wobei t die Anzahl von Molen C in dem Bad darstellt.

14. Verfahren nach einem der Ansprüche 1 bis 10, **dadurch gekennzeichnet, dass** 2t/r größer als 1 oder sogar größer als 1,1 oder sogar mindestens 1,2 ist, wobei t die Anzahl von Molen C in dem Bad darstellt, C La umfasst, C insbesondere zu mehr als 80 Mol-% La ist und X Br umfasst, X insbesondere zu mehr als 80 Mol-% Br ist und 2s/r größer als 1,05 oder sogar mindestens 1,1 ist.

15. Verfahren nach einem der vorstehenden Ansprüche, **dadurch gekennzeichnet, dass** es sich um ein Einkristallzuchtverfahren handelt, das aus dem Verfahren von Bridgman oder Czochralski ausgewählt ist.

16. Verfahren nach vorstehendem Anspruch, **dadurch gekennzeichnet, dass** die ersten zwei Drittel des Wachstumsvolumens des einkristallinen Materials zu weniger als 10 Vol.-% eine Phase umfassen, die sich von der von Elpasolith unterscheidet.

17. Verfahren nach vorstehendem Anspruch, **dadurch gekennzeichnet, dass** die Kristallisation vom Typ Czochralski ist und **dass** die ersten zwei Drittel des Wachstumsvolumens des einkristallinen Materials keine Phase enthalten, die sich von der von Elpasolith unterscheidet.

18. Einkristallwachstumsblock, umfassend ein einkristallines Szintillationsmaterial, das mit einem seine Szintillation aktivierenden Element dotiert ist, erhalten durch ein Verfahren nach einem der vorstehenden Ansprüche, mit Struktur vom Typ Elpasolith mit der theoretischen Zusammensetzung $A_2BC_{(1-y)}M_yX_{(6-y)}$ und der tatsächlichen Formel $A_aB_bC_cM_mX_x$, worin

- A aus Cs, Rb, K, Na ausgewählt ist,
- B aus Li, K, Na ausgewählt ist und Li umfasst,
- C aus Seltenen Erden, Al, Ga ausgewählt ist und eine Seltene Erde umfasst, die aus den Lanthaniden von La bis Lu oder Y ausgewählt ist,
- M aus Erdalkalien ausgewählt ist,
- X aus F, Cl, Br, I ausgewählt ist und Cl, Br oder I umfasst,

wobei y den atomaren Anteil der Substitution von C durch M darstellt und im Bereich von 0 bis 0,05 liegt, a, b, c, m, x die jeweiligen atomaren Anteile an A, B, C, M, X darstellen, das Verhältnis 2b/a im Bereich von 0,97 bis 1,4 liegt, wobei die ersten zwei Drittel des Wachstumsvolumens des Blocks zu weniger als 10 Vol.-% eine Phase aufweisen, die sich von der des Elpasolithmaterials unterscheidet, oder sogar keine Phase enthalten, die sich von der des Elpasolithmaterials unterscheidet.

19. Block nach vorstehendem Anspruch, **dadurch gekennzeichnet, dass** C mindestens eine aktivierende Seltene Erde, ausgewählt aus Ce, Pr, Eu, Tb, Nd, enthält, deren atomarer Anteil so bemessen ist, dass das Verhältnis ihrer atomaren Anteile zur Summe der atomaren Anteile an Element C und M größer als 0,00001 und kleiner als oder gleich 0,1 ist.

20. Verfahren nach einem der vorstehenden Materialansprüche, **dadurch gekennzeichnet, dass** A Cs umfasst.

21. Block nach vorstehendem Anspruch, **dadurch gekennzeichnet, dass** C La umfasst, C insbesondere zu mehr als 80 Mol-% Lanthan ist und X Br umfasst, X insbesondere zu mehr als 80 Mol-% Brom ist.

22. Block nach einem der Ansprüche 18 bis 20, **dadurch gekennzeichnet, dass** C Y umfasst, C insbesondere zu mehr als 80 Mol-% Y ist und X Cl umfasst, X insbesondere zu mehr als 80 Mol-% Cl ist.

23. Block nach einem der Ansprüche 18 und 19, **dadurch gekennzeichnet, dass** A Cs ist, B Li ist, C ein Gemisch aus Y und Ce ist und X Cl ist.

24. Block nach einem der Ansprüche 18 und 19, **dadurch gekennzeichnet, dass** A Cs ist, B Li ist, C ein Gemisch aus La und Ce ist und X Br ist.

**25.** Block nach einem der Ansprüche 18 und 19, **dadurch gekennzeichnet, dass** A Cs ist, B Li ist, C ein Gemisch aus La und Ce ist und X Cl ist.

**26.** Block nach einem der Ansprüche 18 und 19, **dadurch gekennzeichnet, dass** A ein Gemisch aus Cs und Rb ist, B Li ist, C ein Gemisch aus La und Ce ist und X Br ist.

**27.** Block nach einem der Ansprüche 18 und 19, **dadurch gekennzeichnet, dass** A Cs ist, B Li ist, C ein Gemisch aus La und Ce ist und X ein Gemisch aus Cl et Br ist.

**28.** Block nach einem der Ansprüche 18 und 19, **dadurch gekennzeichnet, dass** A Cs ist, B Li ist, C ein Gemisch aus Y und Ce ist und X ein Gemisch aus Cl und Br ist.

**29.** Block nach einem der Ansprüche 18 und 19, **dadurch gekennzeichnet, dass** A Cs ist, B Li ist, C ein Gemisch aus La, Y und Ce ist und X Cl ist.

**30.** Block nach einem der Ansprüche 18 und 19, **dadurch gekennzeichnet, dass** A ein Gemisch aus Cs und Na ist, B ein Gemisch aus Li und Na ist, C ein Gemisch aus Y und Ce ist und X Cl ist.

**31.** Block nach einem der Ansprüche 21 oder 27, **dadurch gekennzeichnet, dass** das Verhältnis 2b/a im Bereich von 1,1 bis 1,4 liegt.

**32.** Block nach einem der vorstehenden Materialansprüche, **dadurch gekennzeichnet, dass** seine Szintillationsenergieauflösung weniger als 6 % oder sogar weniger als 5 % beträgt, gemessen mit einer $^{137}$Cs-Gammastrahlenquelle von 662 keV.

**Claims**

**1.** A single-crystal growth method for producing a crystalline scintillator material of elpasolite-type structure of theoretical composition $A_2BC_{(1-y)}M_yX_{(6-y)}$, said crystalline material having incongruent melting, wherein

- A is selected from Cs, Rb, K, Na,
- B is selected from Li, K, Na, and comprises Li,
- C is selected from the rare earths, Al, Ga, and comprises a rare earth selected from the lanthanides from La to Lu, or Y,
- M is selected from the alkaline earth metals,
- X is selected from F, Cl, Br, I, and comprises Cl, Br or I,

y representing the atomic fraction of substitution of C by M and being in the range from 0 to 0.05, comprising the crystallization thereof by cooling from a molten bath comprising r moles of A and s moles of B, **characterized in that** the crystalline scintillator material is doped with an element that activates the scintillation thereof and **in that** the molten bath in contact with the material contains A and B so that 2s/r is greater than 1.05, said method using a technique selected from the Czochralski, Bridgman, Bagdasarov, Kyropoulos techniques and the vertical gradient freeze technique.

**2.** The method according to the preceding claim, **characterized in that** 2s/r is greater than 1.15 and preferably greater than 1.25 and preferably greater than 1.35 and preferably greater than 1.5.

**3.** The method according to one of the preceding claims, **characterized in that** 2s/r is less than 10 and preferably less than 5 and preferably less than 3.

**4.** The method according to one of the preceding claims, **characterized in that** 2s/r is sufficient for the ratio of twice the atomic fraction of the B-type element to the atomic fraction of the A-type element in the crystalline material to be at least 0.97.

**5.** The method according to one of the preceding claims, **characterized in that** M is selected from Ca, Mg, Sr or Ba.

**6.** The method according to one of the preceding claims, **characterized in that** C comprises at least one rare earth activator selected from Ce, Pr, Eu, Tb, Nd, the atomic fraction of which is such that the ratio of the atomic fraction thereof to the sum of the atomic fractions of element C and M in the crystalline material is greater than 0.00001 and less than or equal to 0.1.

7. The method according to one of the preceding claims, **characterized in that** 2s/r is insufficient to generate the formation of a $B_3C_{(1-y)}M_yX_6$ phase at the start of crystallization.

8. The method according to one of the preceding claims, **characterized in that** B is Li.

9. The method according to one of the preceding claims, **characterized in that** A comprises Cs.

10. The method according to the preceding claim, **characterized in that** C comprises La and X comprises Br.

11. The method according to one of the two preceding claims, **characterized in that** C is more than 80 mol% the lanthanum and X is more than 80 mol% the bromine.

12. The method according to claim 11, **characterized in that** C comprises Y, particularly C is more than 80 mol% Y, and X comprises Cl, particularly X is more than 80 mol% Cl.

13. The method according to one of the preceding claims, **characterized in that** 2t/r is greater than 1, and even greater than 1.1 and even at least 1.2, t representing the number of moles of C in the bath.

14. The method according to one of claims 1 to 10, **characterized in that** 2t/r is greater than 1, and even greater than 1.1 and even at least 1.2, t representing the number of moles of C in the bath, C comprises La, particularly C is more than 80 mol% La, and X comprises Br, particularly X is more than 80 mol% Br, and 2s/r is greater than 1.05, and even at least 1.1.

15. The method according to one of the preceding claims, **characterized in that** it is a single-crystal growth method selected from the Bridgman or Czochralski methods.

16. The method according to the preceding claim, **characterized in that** the first two thirds by growth volume of the single-crystal material comprise less than 10 vol% of a phase other than that of the elpasolite.

17. The method according to the preceding claim, **characterized in that** the crystallization is of the Czochralski type and **in that** the first two thirds by growth volume of the single-crystal material do not contain a phase other than that of the elpasolite.

18. A single-crystal growth ingot comprising a single-crystal scintillator material doped with an element that activates the scintillation thereof obtained by a method according to one of the preceding claims, of elpasolite-type structure of theoretical composition $A_2BC_{(1-y)}M_yX_{(6-y)}$ and of real formula $A_aB_bC_cM_mX_x$, wherein

   - A is selected from Cs, Rb, K, Na,
   - B is selected from Li, K, Na, and comprises Li,
   - C is selected from the rare earths, Al, Ga, and comprises a rare earth selected from the lanthanides from La to Lu, or Y,
   - M is selected from the alkaline earth metals,
   - X is selected from F, Cl, Br, I, and comprises Cl, Br or I,

   y representing the atomic fraction of substitution of C by M, and being in the range from 0 to 0.05, a, b, c, m, x representing the respective atomic fractions of A, B, C, M, X, the ratio 2b/a being in the range from 0.97 to 1.4, the first two thirds by growth volume of said ingot comprising less than 10 vol% of a phase other than that of the elpasolite material, or even not containing any phase other than that of the elpasolite material.

19. The ingot according to the preceding claim, **characterized in that** C contains at least one rare earth activator selected from Ce, Pr, Eu, Tb, Nd, the atomic fraction of which is such that the ratio of the atomic fraction thereof to the sum of the atomic fractions of element C and M is greater than 0.00001 and less than or equal to 0.1.

20. The ingot according to one of the preceding material claims, **characterized in that** A comprises Cs.

21. The ingot according to the preceding claim, **characterized in that** C comprises La, particularly C is more than 80 mol% the lanthanum and X comprises Br, particularly X is more than 80 mol% the bromine.

22. The ingot according to one of claims 18 to 20, **characterized in that** C comprises Y, particularly C is more than 80 mol% Y, and X comprises Cl, particularly X is more than 80 mol% Cl.

23. The ingot according to one of claims 18 and 19, **characterized in that** A is Cs, B is Li, C is a mixture of Y and Ce, and X is Cl.

24. The ingot according to one of claims 18 and 19, **characterized in that** A is Cs, B is Li, C is a mixture of La and Ce, and X is Br.

25. The ingot according to one of claims 18 and 19, **characterized in that** A is Cs, B is Li, C is a mixture of La and Ce, and X is Cl.

26. The ingot according to one of claims 18 and 19, **characterized in that** A is a mixture of Cs and Rb, B is Li, C is a mixture of La and Ce, and X is Br.

27. The ingot according to one of claims 18 and 19, **characterized in that** A is Cs, B is Li, C is a mixture of La and Ce, and X is a mixture of Cl and Br.

28. The ingot according to one of claims 18 and 19, **characterized in that** A is Cs, B is Li, C is a mixture of Y and Ce, and X is a mixture of Cl and Br.

29. The ingot according to one of claims 18 and 19, **characterized in that** A is Cs, B is Li, C is a mixture of La, Y and Ce, and X is Cl.

30. The ingot according to one of claims 18 and 19, **characterized in that** A is a mixture of Cs and Na, B is a mixture of Li and Na, C is a mixture of Y and Ce, and X is Cl.

31. The ingot according to one of claims 21 or 27, **characterized in that** the ratio 2b/a is in the range from 1.1 to 1.4.

32. The ingot according to one of the preceding material claims, **characterized in that** the scintillation energy resolution thereof is less than 6%, or even less than 5%, measured with a 662 keV $^{137}$Cs gamma ray source.

a)   b)   c)

Fig 1

a)   b)   c)

Fig 2

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2005068585 A
- US 8362439 B
- WO 2013041251 A2
- WO 2005021680 A1

**Littérature non-brevet citée dans la description**

- Impact of ion-host interactions on the 5d-to-4f spectra of lanthanide rare-earth-metal ions. II. The Ce-doped elpasolites. **AULL B F et al.** PHYSICAL REVIEW, B. CONDENSED MATTER. AMERICAN INSTITUTE OF PHYSICS, 15 Novembre 1986, vol. 34, 6647-6655
- **W. M. HIGGINS ; J. GLODO ; U. SHIRWADKAR ; A. CHURILOV ; E. VAN LOEF ; R. HAWRAMI ; G. CIAMPI ; C. HINES ; K. S. SHAH.** Bridgman growth of Cs2LiYCl6:Ce and 6Li-enriched Cs2LiYCl6:Ce crystals for high resolution gamma ray and neutron spectrometers. *JOURNAL OF CRYSTAL GROWTH,* 06 Octobre 2009, vol. 312, 1216-1220
- **U. SHIRWADKAR ; J. GLODO ; E. V. VAN LOEF ; R. HAWRAMI ; S. MUKHOPADHYAY ; A. CHURILOV ; W. M. HIGGINS ; K. S. SHAH.** scintillation properties of Cs2LiLaBr6 (CLLB) crystals with varying Ce3+ concentration. *NUCLEAR INSTRUMENTS AND METHODS IN PHYSICS RESEARCH A,* 07 Septembre 2010, vol. 652, 268-270
- **R. B JAMES ; L: A: FRANKS ; A; BURGER.** Hard X-Ray, GammaRay, and Neutron Detector Physics XI. *Proc. of SPIE,* 31 Décembre 2009, vol. 7449, 74490E-1, 74490E-7
- **F. PATRICK DOTY et al.** Elpasolite Scintillators. *Sandia Report SAND2012-9951,* 01 Décembre 2012